# EUROPEAN PATENT APPLICATION

(11) **EP 4 782 503 A1**
(43) Date of publication of application: **29.07.2026**
(21) Application number: 26151045.7
(22) Date of filing: 09.01.2026
(51) Int. Cl.: C08L 79/08, C08G 73/12

(54) **THERMOSETTING MALEIMIDE RESIN COMPOSITION FOR STRESS-RELIEF LAYER FOR GLASS-CORE SUBSTRATE AND PRINTED WIRING BOARD INCLUDING THE SAME**

(30) Priority: 24.01.2025 JP 2025010221
(71) Applicant: SHIN-ETSU CHEMICAL CO., LTD.,, Chiyoda-ku, Tokyo 1000005 (JP)
(72) Inventor: TSUTSUMI, Yoshihiro, Annaka-shi 3790224 (JP); KUDO, Shunsuke, Annaka-shi 3790224 (JP); HOSOKAWA, Daiki, Annaka-shi 3790224 (JP)
(74) Representative: Angerhausen, Christoph

(57) **Abstract**

A thermosetting maleimide resin composition for a stress-relief layer for a glass-core substrate includes a component (A) that is a maleimide compound having, in one molecule, one or more hydrocarbon groups derived from one or more skeletons selected from dimer diamine skeletons and trimer triamine skeletons, the component (A) being contained in an amount of 30% to 99% by mass based on the total composition; a component (B) that is an epoxy resin having two or more epoxy groups in one molecule, the component (B) being contained in an amount of 0.05 to 25 parts by mass per 100 parts by mass of the component (A); and a component (C) that is an anionic polymerization initiator, the component (C) being contained in an amount of 0.1 to 5 parts by mass per 100 parts by mass of the total of the components (A) and (B).

## Description

### BACKGROUND OF THE INVENTION

### Field of the Invention

The present invention relates to a thermosetting maleimide resin composition for a stress-relief layer for a glass-core substrate and a printed wiring board including the same.

### Background Art

In recent years, development using glass bases as cores has been actively pursued. In the case of glass bases, the glass cloth that forms the core of current organic substrates is replaced with a glass panel, and the redistribution layers (RDL) above and below the core layer will be fabricated in the same way as in organic substrates. The advantages of using glass bases can be broadly divided into five categories.

The first advantage is that the glass panel made of silicon oxide has a thermal expansion coefficient close to that of silicon, which serves as the base material of silicon dies and silicon interposers. This halves the distortion caused by heat generation and other factors compared with organic substrates, thereby allowing for a larger substrate area. The second advantage is the extremely high flatness of the glass panel, thereby facilitating further miniaturization of wiring. The third advantage is that electrodes penetrating the core can be fabricated at a higher density than in organic substrates. The fourth advantage is that, because glass bases exhibit lower loss than organic substrates, semiconductors can operate at higher frequencies. The fifth advantage is that glass bases can function at high temperatures, which is difficult for organic substrates, thereby enabling further advances in power delivery performance.

In contrast, there are also many disadvantages to using a glass-core substrate. For example, if the materials previously used for organic substrates, which are particularly build-up materials based on epoxy resin compositions (see JP-A-2010-90238 and JP-A-2011-132507), are used as they are, warpage may increase due to stress, possibly causing the glass to crack. Furthermore, the adhesion strength of the build-up material to glass, especially its long-term adhesion, is insufficient.

In particular, regarding improvements in stress and adhesion strength, these problems may be addressed by using a stress-relief layer that provides excellent adhesion to glass. Examples of candidate materials for such a stress-relief layer include compositions containing a maleimide compound (special maleimide compound) having a dimer diamine skeleton and a radical polymerization initiator (see WO-A-2016-114287 and JP-A-2018-12248); and compositions obtained by adding a thermoplastic resin thereto (see WO-A-2018-16489 and JP-A-2022-58409). These materials are desirable because they have a low elastic modulus and provide high initial adhesion. However, it has been found that they also have disadvantages, such as a significant decrease in adhesion strength to glass after moisture absorption.

### SUMMARY OF THE INVENTION

Accordingly, it is an object of the present invention to provide a thermosetting maleimide resin composition for a stress-relief layer for a glass-core substrate, in which the composition not only functions to relieve stress due to its low elastic modulus but also exhibits high adhesion to glass over a long period of time and in various environments, and a printed wiring board including the composition.

The inventors of the present invention diligently conducted a series of studies to solve the aforementioned problems, and completed the invention by finding that the following thermosetting maleimide resin composition can achieve the above object, leading to the completion of the present invention.
<1> A thermosetting maleimide resin composition for a stress-relief layer for a glass-core substrate, comprising the components (A) to (C) of:
   (A) a maleimide compound having, in one molecule, one or more hydrocarbon groups derived from one or more skeletons selected from dimer diamine skeletons and trimer triamine skeletons, the component (A) being contained in an amount of 30% to 99% by mass based on the total composition;
   (B) an epoxy resin having two or more epoxy groups in one molecule, the component (B) being contained in an amount of 0.05 to 25 parts by mass per 100 parts by mass of the component (A); and
   (C) an anionic polymerization initiator, the component (C) being contained in an amount of 0.1 to 5 parts by mass per 100 parts by mass of the total of the components (A) and (B),
   wherein the thermosetting maleimide resin composition provides a test specimen exhibiting:
   (1) a peel strength of 0.8 kN/m or more, as determined at 23°C with a peel angle of 90° and a crosshead speed of 50 mm/min, in accordance with JIS C6481:1996,
   (2) a peel strength of 0.5 kN/m or more, as determined at 23°C with a peel angle of 90° and a crosshead speed of 50 mm/min in accordance with JIS C6481:1996, after the test specimen has been left to stand at 85°C and a relative humidity of 85% for 24 hours, and
   (3) a peel strength of 0.8 kN/m or more, as determined at 23°C with a peel angle of 90°, and a crosshead speed of 50 mm/min in accordance with JIS C6481:1996, after the test specimen has been left to stand at 150°C for 24 hours,
   wherein the test specimen is prepared by laminating a copper foil having a thickness of 18 µm and a surface roughness (Rz) of 0.6 µm (as measured by a method in accordance with JIS B 0601) onto a borosilicate glass base having a thickness of 1 mm in such a manner that a stress-relief layer is provided between the glass base and the copper foil, the stress-relief layer being formed by applying or laminating the thermosetting maleimide resin composition at a thickness of 10 µm and curing the composition at 180°C for 2 hours.
<2> The thermosetting maleimide resin composition for a stress-relief layer for a glass-core substrate according to <1>, wherein the maleimide compound as the component (A) is a maleimide compound represented by formula (1) defined as: 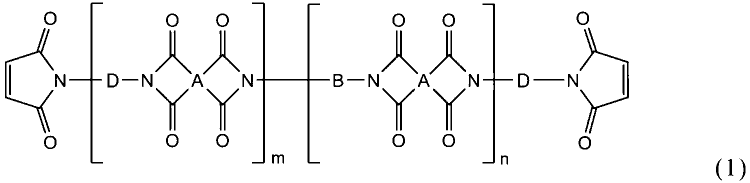 wherein, in the formula (1), each A independently represents a tetravalent organic group having a cyclic structure, each B independently represents a divalent hydrocarbon group having 6 to 60 carbon atoms, each D independently represents a divalent alicyclic hydrocarbon group having 6 to 200 carbon atoms or a hydrocarbon group derived from one or more skeletons selected from dimer diamine skeletons and trimer triamine skeletons, provided that at least one D represents a hydrocarbon group derived from one or more skeletons selected from dimer diamine skeletons and trimer triamine skeletons, m represents an average repeating unit number of 1 to 100, n represents an average repeating unit number of 1 to 200, the order of repeating units enclosed in square brackets subscripted with m and n is not limited, and the mode of linkage is any of alternating, block, and random types.
<3> The thermosetting maleimide resin composition for a stress-relief layer for a glass-core substrate according to <1>, wherein the maleimide compound as the component (A) is a maleimide compound represented by formula (2) defined as: 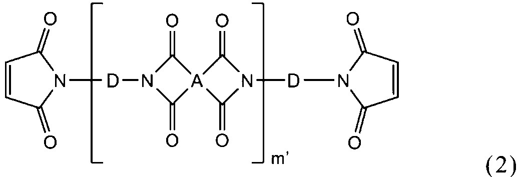 wherein, in the formula (2), each A independently represents a tetravalent organic group having a cyclic structure, each D independently represents a divalent alicyclic hydrocarbon group having 6 to 200 carbon atoms or a hydrocarbon group derived from one or more skeletons selected from dimer diamine skeletons and trimer triamine skeletons, provided that at least one D represents a hydrocarbon group derived from one or more skeletons selected from dimer diamine skeletons and trimer triamine skeletons, and m' represents an average repeating unit number of 1 to 100.
<4> The thermosetting maleimide resin composition for a stress-relief layer for a glass-core substrate according to <2>, wherein each A in the formula (1) independently represents any one of tetravalent organic groups represented by structural formulae defined as: 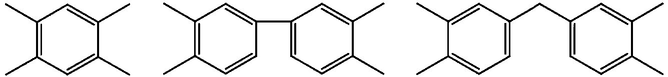 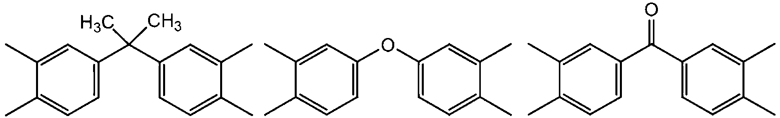 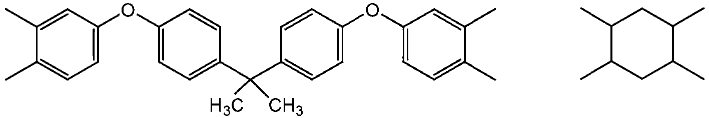 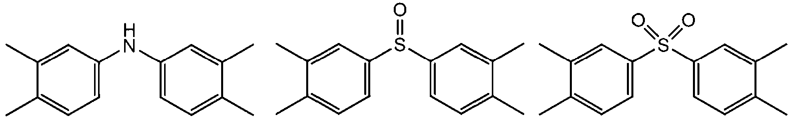 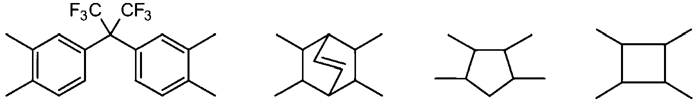 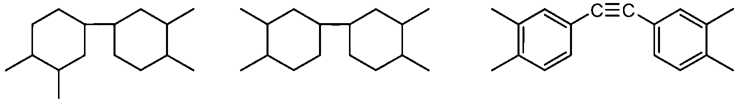 wherein, in each of the above structural formulae, bonding arms that are not bonded are bonded to carbonyl carbons of cyclic imide structures in the formula (1).
<5> The thermosetting maleimide resin composition for a stress-relief layer for a glass-core substrate according to any one of <1> to <4>, wherein the epoxy resin (B) is an amino-type epoxy resin.
<6> The thermosetting maleimide resin composition for a stress-relief layer for a glass-core substrate according to any one of <1> to <5>, wherein the anionic polymerization initiator (C) is an imidazole compound having a triazine ring.
<7> A printed wiring board using the thermosetting maleimide resin composition according to any one of <1> to <6>.

The composition of the present invention not only functions to relieve stress due to its low elastic modulus but also exhibits high adhesion to glass over a long period of time and in various environments. The thermosetting maleimide resin composition of the present invention is therefore suitable for use in a stress-relief layer for a glass-core substrate as well as in a printed wiring board.

### DETAILED DESCRIPTION OF THE INVENTION

Embodiments of the present invention will be described in more detail below.

### [(A) Maleimide Compound Having, in One Molecule, One or More Hydrocarbon Groups Derived from One or More Skeletons Selected from Dimer Diamine Skeletons and Trimer Triamine Skeletons]

The component (A) according to an embodiment of the present invention is a maleimide compound having, in one molecule, one or more hydrocarbon groups derived from one or more skeletons selected from dimer diamine skeletons and trimer triamine skeletons. Since the component (A) has, in one molecule, one or more hydrocarbon groups derived from one or more skeletons selected from dimer diamine skeletons and trimer triamine skeletons, a cured product of a composition containing the component (A) exhibits a low elastic modulus due to its low crosslink density and exhibits improved adhesion resulting from enhanced wettability to a base, such as glass in this case. In addition, the hydrocarbon group or groups derived from one or more skeletons selected from dimer diamine skeletons and trimer triamine skeletons are also effective in improving dielectric properties, namely, reducing the relative dielectric constant and the dielectric loss tangent.

The term "dimer diamine" as used herein refers to a compound obtained by aminomethylation of carboxy groups in a liquid dibasic acid mainly composed of a C₃₆ dicarboxylic acid produced by dimerization of a C₁₈ unsaturated fatty acid derived from natural substances, such as plant-based oils and fats, the dibasic acid being known as a "dimer acid". The dimer acid does not have a single molecular skeleton, but rather has multiple structures and exists in various isomeric forms. Representative dimer acids are classified as linear type (a), monocyclic type (b), aromatic ring type (c), and polycyclic type (d). In the present specification, the term "dimer acid skeleton" refers to a group derived from a dimer diamine having a structure in which the carboxy groups of such dimer acid are replaced with primary aminomethyl groups. That is, the component (A) preferably has, as a dimer acid skeleton, a group in which the two carboxy groups of each of the dimer acids (a) to (d) illustrated below are replaced with the methyl groups.

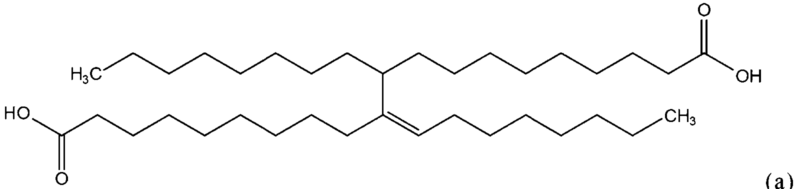

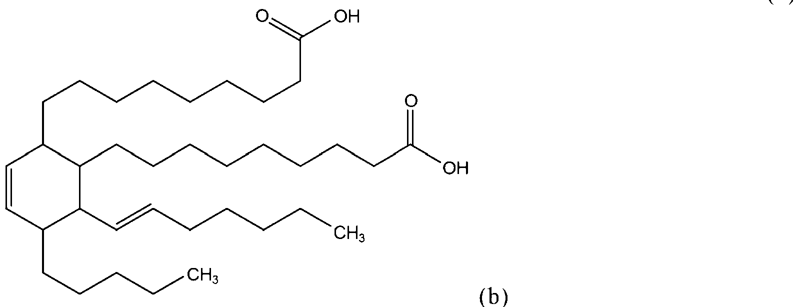

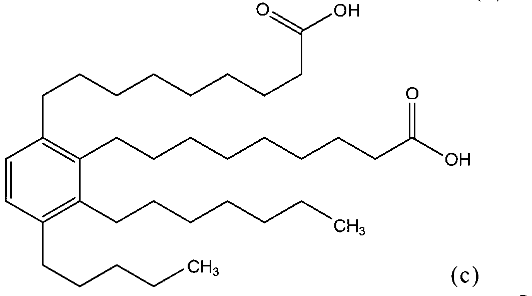

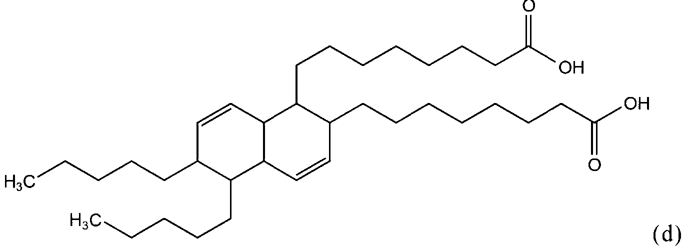

From the viewpoints of heat resistance and reliability of the cured product, the hydrocarbon group derived from the dimer diamine skeleton in the maleimide compound as the component (A) preferably has a structure having a reduced content of carbon-carbon double bonds in the hydrocarbon group derived from the dimer diamine skeleton due to a hydrogenation reaction.

In the present specification, the term "trimer triamine" refers to a compound obtained by aminomethylation of carboxy groups contained in a by-product that is typically generated during the synthesis of a dimer acid and is known as a "trimer acid". The trimer acid is a tribasic acid mainly composed of a C₅₄ tricarboxylic acid produced by trimerization of C₁₈ unsaturated fatty acids derived from natural substances such as plant-derived oils and fats. Similar to the dimer acid, the trimer acid does not consist only of a single molecular skeleton but rather has multiple structures and exists in various isomeric forms.

From the viewpoints of heat resistance and reliability of the cured product, the hydrocarbon group derived from the trimer triamine skeleton in the maleimide compound as the component (A) preferably has a structure having a reduced content of carbon-carbon double bonds in the hydrocarbon group derived from the trimer triamine skeleton due to a hydrogenation reaction.

The maleimide compound as the component (A) is preferably a maleimide compound represented by the following formula (1): 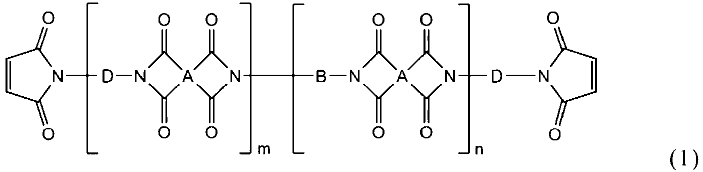 wherein, in the formula (1), each A independently represents a tetravalent organic group having a cyclic structure, each B independently represents a divalent hydrocarbon group having 6 to 60 carbon atoms, each D independently represents a divalent alicyclic hydrocarbon group having 6 to 200 carbon atoms or a hydrocarbon group derived from one or more skeletons selected from dimer diamine skeletons and trimer triamine skeletons, provided that at least one D represents a hydrocarbon group derived from one or more skeletons selected from dimer diamine skeletons and trimer triamine skeletons, m represents an average repeating unit number of 1 to 100, n represents an average repeating unit number of 1 to 200, the order of repeating units enclosed in square brackets subscripted with m and n is not limited, and the mode of linkage is any of alternating, block, and random types.

In the formula (1), each A independently represents a tetravalent organic group having a cyclic structure and is preferably any of the tetravalent organic groups represented by the following formulae: 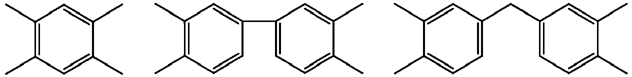 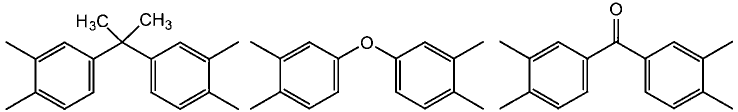 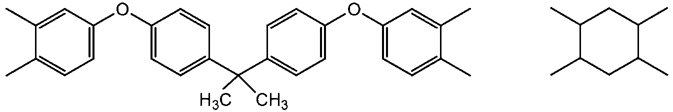 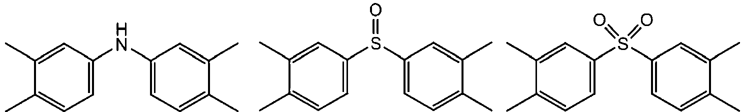 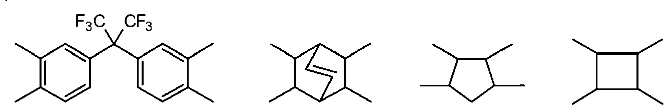 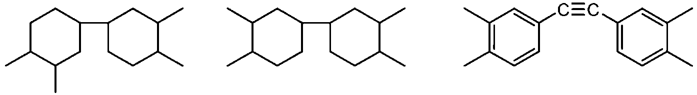 wherein, in each of the above structural formulae, bonding arms that are not bonded are bonded to carbonyl carbons of cyclic imide structures in the formula (1).

In the formula (1), n represents an average repeating unit number of 1 to 200, preferably from 1 to 60, and more preferably from 1 to 50. If n is too large, the solubility and flowability may decrease, resulting in poor formability.

In the formula (1), m represents an average repeating unit number of 1 to 100, preferably from 1 to 60, and more preferably from 1 to 50. If m is too large, the solubility and flowability may decrease, resulting in poor formability.

In the formula (1), each D independently represents a divalent alicyclic hydrocarbon group having 6 to 200 carbon atoms, preferably 8 to 60 carbon atoms, and more preferably 10 to 55 carbon atoms, or a hydrocarbon group derived from one or more skeletons selected from dimer diamine skeletons and trimer triamine skeletons. However, at least one D represents a hydrocarbon group derived from one or more skeletons selected from dimer diamine skeletons and trimer triamine skeletons. The divalent alicyclic hydrocarbon group is preferably a divalent alicyclic hydrocarbon group having 6 to 200 carbon atoms, and more preferably 8 to 60 carbon atoms. Among these, more preferred is a branched divalent alicyclic hydrocarbon group in which at least one hydrogen atom in the divalent alicyclic hydrocarbon group is replaced with an alkyl or alkenyl group having 6 to 60 carbon atoms, preferably 8 to 60 carbon atoms, and more preferably 10 to 55 carbon atoms. The branched divalent alicyclic hydrocarbon group may be a saturated aliphatic hydrocarbon group or an unsaturated hydrocarbon group, and may have an alicyclic structure that is present in a midway through its molecular chain.

In the formula (1), each B independently represents a divalent hydrocarbon group having 6 to 60 carbon atoms. Specifically, each B independently represents a divalent aliphatic hydrocarbon group having 6 to 60 carbon atoms or an aromatic hydrocarbon group having 6 to 60 carbon atoms. Preferably, each B independently represents a divalent aliphatic hydrocarbon group or an aromatic hydrocarbon group having 6 to 30 carbon atoms. The divalent hydrocarbon group may include a cyclic structure or a branched structure, but does not include a hydrocarbon group derived from one or more skeletons selected from dimer acid skeletons and trimer acid skeletons. The divalent aromatic hydrocarbon group may have a bonding arm directly bonded to an aromatic ring, or may have a bonding arm bonded to an aromatic ring through a linear or branched divalent aliphatic hydrocarbon group.

The maleimide compound as the component (A) may be a maleimide compound represented by the following formula (2): 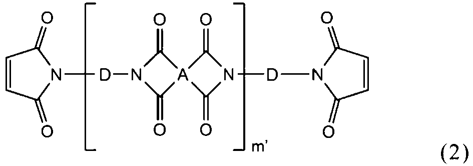 wherein, in the formula (2), each A independently represents a tetravalent organic group having a cyclic structure, each D independently represents a divalent alicyclic hydrocarbon group having 6 to 200 carbon atoms or a hydrocarbon group derived from one or more skeletons selected from dimer diamine skeletons and trimer triamine skeletons, provided that at least one D represents a hydrocarbon group derived from one or more skeletons selected from dimer diamine skeletons and trimer triamine skeletons, and m' represents an average repeating unit number of 1 to 100.

The A and D groups in the formula (2) are the same as the A and D groups in the formula (1).

The number-average molecular weight of the maleimide compound as the component (A) is preferably, but not necessarily, from 1,500 to 50,000, more preferably from 2,000 to 30,000, from the viewpoint of handleability of the composition.

The term "number-average molecular weight" used herein refers to a number-average molecular weight determined by gel permeation chromatography (GPC) measured using polystyrene standards under the conditions described below.

### Measurement Conditions

Eluent: Tetrahydrofuran (THF)
Flow rate: 0.35 mL/min
Detector: Differential refractive index detector (RI)
Column: TSK Guardcolumn SuperH-L
   TSKgel SuperHZ4000 (4.6 mm I.D. × 15 cm × 1)
   TSKgel SuperHZ3000 (4.6 mm I.D. × 15 cm × 1)
   TSKgel SuperHZ2000 (4.6 mm I.D. × 15 cm × 2)
   (All of the above are manufactured by Tosoh Corporation)
Column temperature: 40°C
Sample injection volume: 5 µL (THF solution with a concentration of 0.2% by mass)

The component (A) may be used singly or in combination of two or more types thereof.

The amount of component (A) contained in the entire thermosetting maleimide resin composition according to an embodiment of the present invention is from 30% to 99% by mass, preferably from 50% to 95% by mass.

### [(B) Epoxy Resin Having Two or More Epoxy Groups in One Molecule]

In the thermosetting maleimide resin composition according to an embodiment of the present invention, an epoxy resin having two or more epoxy groups in one molecule is used as a component (B). Incorporation of the epoxy resin enables the resin composition according to an embodiment of the present invention to particularly exhibit enhanced adhesion to glass and improved other mechanical properties.

The component (B) is preferably an epoxy resin having a glycidyl group, in consideration of reactivity, storage stability, and the like.

Examples of the component (B) include phenol novolac-type epoxy resins, bisphenol A-type epoxy resins, bisphenol F-type epoxy resins, biphenol-type epoxy resins, naphthalene-type epoxy resins, anthracene-type epoxy resins, naphthol-type epoxy resins, xylylene-type epoxy resins, biphenyl-type epoxy resins, biphenyl aralkyl-type epoxy resins, trisphenol methane-type epoxy resins, alicyclic-type epoxy resins, glycidyl amine-type epoxy resins, dicyclopentadiene-type epoxy resins, stilbene-type epoxy resins, sulfur atom-containing epoxy resins, phosphorus atom-containing epoxy resins, and amino-type epoxy resins.

The component (B) used is preferably liquid at room temperature (25°C) from the viewpoints of compatibility and wettability with the base. In particular, a glycidyl amine-type epoxy resin is preferred.

The amount of the component (B) contained is 0.05 to 25 parts by mass, preferably 0.1 to 20 parts by mass, per 100 parts by mass of the component (A). Within the above range, the curing speed during forming is appropriate, which is preferable. In addition, the balance among heat resistance, moisture resistance, and low elastic modulus of the resulting cured product is improved, and the adhesion to glass is also likely to be enhanced.

The epoxy resin as the component (B) may be used singly or in combination of two or more types thereof.

### [(C) Anionic Polymerization Initiator]

The anionic polymerization initiator as the component (C) is incorporated to initiate and promote the curing reaction of the maleimide compound as the component (A). Examples of the anionic polymerization initiator include basic compounds, such as imidazoles and tertiary amines, and organophosphorus compounds. Among these, imidazoles, such as 2-undecylimidazole (C11Z, manufactured by Shikoku Kasei Holdings Corporation) are preferably used.

A radical polymerization initiator may sometimes be used in order to promote the reaction of the functional groups in the component (A). In general, a radical polymerization initiator may sometimes be used for curing a thermosetting resin that does not react even when an anionic polymerization initiator is used, or for promoting the curing of the maleimide compound. Although the radical polymerization initiator may be used in combination with the anionic polymerization initiator, it is preferable in an embodiment of the present invention to use only the anionic polymerization initiator.

Among the imidazoles, imidazole compounds having a triazine ring are more preferred. The triazine ring is effective in improving adhesion and also provides moderate curability and storage stability.

Examples of the imidazole compounds having a triazine ring include 2,4-diamino-6-[2'-methylimidazolyl-(1')]-ethyl-s-triazine (trade name: 2MZ-A, manufactured by Shikoku Kasei Holdings Corporation), 2,4-diamino-6-[2'-undecylimidazolyl-(1')]-ethyl-s-triazine (trade name: C11Z-A, manufactured by Shikoku Kasei Holdings Corporation), 2,4-diamino-6-[2'-ethyl-4'-methylimidazolyl-(1')]-ethyl-s-triazine (trade name: 2E4MZ-A, manufactured by Shikoku Kasei Holdings Corporation), and 2,4-diamino-6-[2'-methylimidazolyl-(1')]-ethyl-s-triazine isocyanuric acid adduct (trade name: 2MA-OK, manufactured by Shikoku Kasei Holdings Corporation).

Examples of the tertiary amines include triethylamine, benzyldimethylamine, α-methylbenzyldimethylamine, and 1,8-diazabicyclo[5.4.0]undecene-7.

The amount of the component (C) contained is from 0.1 to 5 parts by mass per 100 parts by mass of the total of the components (A) and (B), and preferably from 0.5 to 3 parts by mass. When the amount of the component (C) contained is less than 0.1 parts by mass per 100 parts by mass of the components (A) and (B), the curability is insufficient, which is not preferable. When the amount is more than 5 parts by mass, the storage stability of the composition deteriorates, which is not preferable.

The component (C) may be used singly or in combination of two or more types thereof.

### [Further Additives]

The thermosetting maleimide resin composition according to an embodiment of the present invention may further contain, as needed, various additives as long as the advantageous effects of the present invention are not impaired. Examples of such further additives are described below.

### [Inorganic Filler]

The composition according to an embodiment of the present invention may further contain an inorganic filler. The inorganic filler is incorporated for the purpose of improving the strength and rigidity of the cured product of the thermosetting maleimide resin composition according to an embodiment of the present invention, or for adjusting the thermal expansion coefficient and the dimensional stability of the cured product. As the inorganic filler, those commonly incorporated in epoxy resin compositions or silicone resin compositions can be used. Silica particles, such as fused silica and crystalline silica, and boron nitride are preferred. In this application, it is highly likely that a lower relative dielectric constant and a lower dielectric loss tangent will be required in the future. In such cases, hollow inorganic fillers, such as hollow silica and hollow glass, are more preferable.

On the other hand, inorganic particles such as alumina, talc, magnesium hydroxide, and zinc oxide often have a low dielectric loss tangent but a high relative dielectric constant, or both a high dielectric loss tangent and a high relative dielectric constant, which is not preferred depending on the substrate design.

The average particle diameter and shape of the inorganic filler are not particularly limited, but from the viewpoint of workability of the substrate, spherical inorganic filler having an average particle diameter of 0.5 to 5 µm is particularly preferred. The average particle diameter is a value determined as the median diameter (D₅₀ or a median diameter determined on a volume basis) in a particle size distribution measurement by a laser diffraction method.

The inorganic filler is preferably surface-treated with a silane coupling agent having an organic group that can react with a maleimide group or an epoxy group, in order to improve its properties. Examples of the silane coupling agent include epoxy group-containing alkoxysilanes, amino group-containing alkoxysilanes, (meth)acryloyl group-containing alkoxysilanes, and alkenyl group-containing alkoxysilanes.

Among these, amino group-containing alkoxysilanes are preferably used as the silane coupling agent. Specific examples thereof include N-phenyl-3-aminopropyltrimethoxysilane, N-(2-aminoethyl)-3-aminopropyltrimethoxysilane, and 3-aminopropyltrimethoxysilane.

The inorganic filler may be used singly or in combination of two or more types thereof. The amount of the inorganic filler added is preferably 0 to 400 parts by mass, more preferably 0 to 300 parts by mass, per 100 parts by mass of the total of the components (A) and (B). It is preferable not to add an inorganic filler, because this results in better workability of the thermosetting maleimide resin composition according to an embodiment of the present invention and also exhibits excellent stress-relaxation performance.

### [Thermosetting Resin Having Reactive Group That Can React with Maleimide Group or Epoxy Group]

In an embodiment of the present invention, a thermosetting resin having a reactive group that can react with a maleimide group or an epoxy group may further be added to the thermosetting resin layer.

Examples thereof include, but are not limited to, various resins other than the component (A), such as melamine resins, silicone resins, cyclic imide resins, such as maleimide compounds other than the component (A), urea resins, thermosetting polyimide resins, modified polyphenylene ether resins, thermosetting acrylic resins, and epoxy-silicone hybrid resins. In addition, curing agents commonly used for epoxy resins, such as phenolic curing agents, amine curing agents, acid anhydride curing agents, and active ester curing agents, are also included in this component.

Examples of the reactive group that can react with a maleimide group or an epoxy group include a maleimide group, a hydroxy group (including a phenolic hydroxy group), an acid anhydride group, alkenyl groups, such as an allyl group and a vinyl group, a (meth)acryl group, and a thiol group.

### [Others]

In addition to the above components, non-functional silicone oils, reactive diluents, thermoplastic resins, thermoplastic elastomers, organic synthetic rubber, photosensitizers, light stabilizers, polymerization inhibitors, flame retardants, pigments, dyes, adhesion promoters, ion-trapping agents, and the like may be incorporated. However, in particular, thermoplastic resins and thermoplastic elastomers having poor compatibility, which result in phase separation, are preferably not used.

Furthermore, a silane coupling agent, such as an epoxy group-containing alkoxysilane, an amino group-containing alkoxysilane, a (meth)acryloyl group-containing alkoxysilane, or an alkenyl group-containing alkoxysilane, which is used for surface-treating the inorganic filler, may be separately incorporated into the thermosetting maleimide resin composition according to an embodiment of the present invention.

From the viewpoint of environmental and human health impact, the addition of an organic fluorine compound is not preferred.

The thermosetting maleimide resin composition according to an embodiment of the present invention can be dissolved in an organic solvent and handled as a varnish or a slurry. Converting the composition into a varnish facilitates film formation. Any organic solvent can be used without limitation as long as it dissolves the thermosetting resin having a reactive group that can react with the component (A), the component (B), and/or other additives. Examples thereof include anisole, tetralin, mesitylene, xylene, toluene, tetrahydrofuran (THF), dimethylformamide (DMF), dimethyl sulfoxide (DMSO), and acetonitrile. Among these, aromatic organic solvents, such as anisole, tetralin, mesitylene, xylene, and toluene, are preferred. Ketone solvents having a low boiling point of 100°C or lower, such as methyl ethyl ketone (MEK) and methyl isobutyl ketone (MIBK), are also often used to prepare varnishes and slurries. The maleimide compound as the component (A) used in an embodiment of the present invention has low solubility in these ketone solvents. Therefore, the use of these ketone solvents may be undesirable. These organic solvents may be used singly or in combination of two or more types thereof.

Examples of the method for producing the thermosetting maleimide resin composition according to an embodiment of the present invention include a method in which the component (A), the component (B), and the component (C), and other additives added as needed, are mixed using, for example, a planetary mixer (manufactured by Inoue Mfg., Inc.) or a mixer such as a Thinky Conditioning Mixer (manufactured by Thinky Corporation).

This thermosetting maleimide resin composition can be formed into an uncured resin sheet or an uncured resin film by applying the above-mentioned varnish to a base and then volatilizing the organic solvent. Furthermore, the uncured resin sheet or film can be cured to form a cured resin sheet or a cured resin film. Methods for producing sheets and films are exemplified below, but the methods are not limited to these.

For example, a thermosetting resin composition (varnish) dissolved in an organic solvent is applied to a base, and then the base is heated at a temperature of usually 80°C or higher, preferably 100°C or higher, for 0.5 to 20 minutes to remove the organic solvent, and then further heated at a temperature of 130°C or higher, preferably 150°C or higher, for 0.5 to 10 hours, thereby forming a strong cured resin coating with a flat surface. The temperature in the drying step for removing the organic solvent and the subsequent heat curing step may be constant, but it is preferable to increase the temperature stepwise. This allows the organic solvent to be efficiently removed from the composition, and also allows the curing reaction of the resin to proceed efficiently. Examples of a method for applying the varnish include, but are not limited to, spin coating, slit coating, spray coating, dip coating, and bar coating.

As the base, a typical resin base can be used. Examples of the material of the resin base include polyolefin resins, such as polyethylene (PE) resins, polypropylene (PP) resins, and polystyrene (PS) resins; and polyester resins, such as polyethylene terephthalate (PET) resins, polybutylene terephthalate (PBT) resins, and polycarbonate (PC) resins. The surface of the base may be subjected to release treatment. The thickness of the coating layer is not particularly limited. In an embodiment of the present invention, from the viewpoint of use as a stress-relief layer, the thickness after solvent removal is in the range of 1 to 50 µm, preferably 3 to 20 µm. A cover film may be provided on the coating layer. Alternatively, the components may be premixed in advance and extruded into a sheet or film using a melt kneader, and then used as is.

A resin-coated copper foil can be produced by using a copper foil as a base and forming an uncured or semi-cured film on the copper foil in the same manner as described above. Alternatively, as described above, a resin-coated copper foil can be obtained by dissolving a thermosetting resin in an organic solvent to prepare a varnish, applying the varnish onto a release-treated polyethylene terephthalate (PET) film, removing the solvent by drying to form a film, laminating the film to a copper foil, and peeling off the PET film. In this case, the lamination conditions are not particularly limited; however, it is preferable to perform the lamination while heating at a temperature of 80°C to 130°C under a pressure of 0.1 to 1.0 MPa for 0.5 to 5 minutes.

The film obtained in this manner can be used as a stress-relief layer for a glass-core substrate. A printed wiring board is produced by laminating the film onto a glass base, subjecting the laminated structure to thermal curing, plating, or other processing, and then laminating a resin composition, mainly of a thermosetting type, known as a build-up film. Known methods can be employed for various processes required to produce the printed wiring board, including a circuit formation process, a desmear process, and a plating process.

The method for forming the stress-relief layer is not limited to lamination of the film. Examples thereof include a method in which the varnish is applied to a glass base by spin coating; and a method in which the varnish is applied to a glass base by slit coating and then the solvent is removed by drying.

The glass base serving as the core may be made of any type of glass. Suitable examples thereof include alkali-free glass, borosilicate glass, and quartz glass. Typically, many thermosetting resin compositions have poor adhesion to glass bases. Even if the initial adhesion is good, the adhesive strength often decreases significantly in long-term tests.

In view of the foregoing background, a material that satisfies the peel strength measured by the following method exhibits high reliability and is also highly reliable when used in a printed wiring board.

### (Test Specimen Preparation Conditions)

A test specimen is prepared by laminating a copper foil having a thickness of 18 µm and a surface roughness (Rz) of 0.6 µm (as measured by a method in accordance with JIS B 0601) onto a borosilicate glass base (a glass base of an alkali-free glass may also be used) having a thickness of 1 mm in such a manner that a stress-relief layer is provided between the glass base and the copper foil, the stress-relief layer being formed by applying or laminating the resin composition at a thickness of 10 µm and then curing the composition at 180°C for 2 hours.

### (Peel Strength Measurement and Reliability Test Conditions)

(1) The peel strength between the copper foil and the resin, as determined at 23°C with a peel angle of 90° and a crosshead speed of 50 mm/min in accordance with JIS C6481:1996, is 0.8 kN/m or more.
(2) The peel strength between the copper foil and the resin, as determined at 23°C with a peel angle of 90°, and a crosshead speed of 50 mm/min in accordance with JIS C6481:1996, after the test specimen has been left to stand at 85°C and a relative humidity of 85% for 24 hours is 0.5 kN/m or more.
(3) The peel strength between the copper foil and the resin, as determined at 23°C with a peel angle of 90° and a crosshead speed of 50 mm/min in accordance with JIS C6481:1996, after the test specimen has been left to stand at 150°C for 24 hours is 0.8 kN/m or more.

The thermosetting maleimide resin composition according to an embodiment of the present invention satisfies the above conditions and is highly reliable when used for a printed wiring board. It also has a low elastic modulus and is highly effective in stress relaxation. Furthermore, in the future, dielectric properties of, for example, a low dielectric constant and a low dielectric loss tangent may be required for build-up materials. The thermosetting maleimide resin composition of the present invention is useful for printed wiring board applications because it contains the component (A) and therefore has the above-mentioned dielectric properties.

### WORKING EXAMPLES

The present invention will be specifically described below with reference to working examples and comparative examples, but the present invention is not limited to the following examples.

The components used in the working examples and comparative examples are described below. For products available as varnish, the solvent was removed before use. The silica slurry was used as it was.

### [(A-1) Maleimide Compound]

(A-1-1): A bismaleimide compound represented by the following formula (BMI-2500, manufactured by Designer Molecules Inc., solid at 25°C): 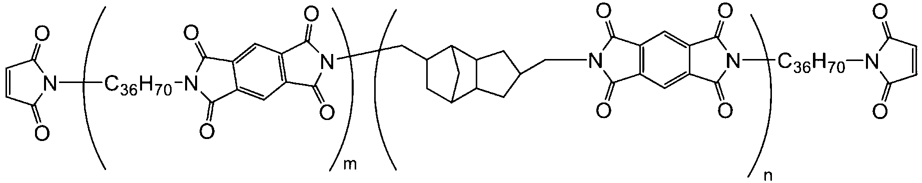 wherein n ≈ 5 (average value), m ≈ 1 (average value), and -C₃₆H₇₀- represents a structure derived from a dimer acid skeleton.
(A-1-2): A hydrocarbon group-containing bismaleimide compound derived from a dimer acid skeleton, represented by the following formula (trade name: SLK-3000, manufactured by Shin-Etsu Chemical Co., Ltd., solid at 25°C): 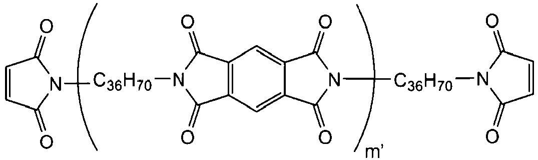 wherein m' ≈ 5 (average value), and -C₃₆H₇₀- represents a structure derived from a dimer acid skeleton.
(A-1-3): A hydrocarbon group-containing bismaleimide compound derived from a dimer acid skeleton, represented by the following formula (trade name: SLK-1500, manufactured by Shin-Etsu Chemical Co., Ltd., syrupy paste at 25°C): 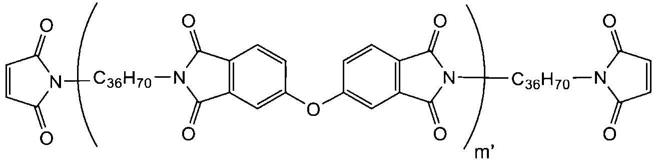 wherein m' ≈ 4, and -C₃₆H₇₀- represents a structure derived from a dimer acid skeleton.

### [(A-2) Maleimide Compound for Comparative Examples]

(A-2-1): A bismaleimide compound represented by the following formula (trade name: SLK-6100, manufactured by Shin-Etsu Chemical Co., Ltd.): 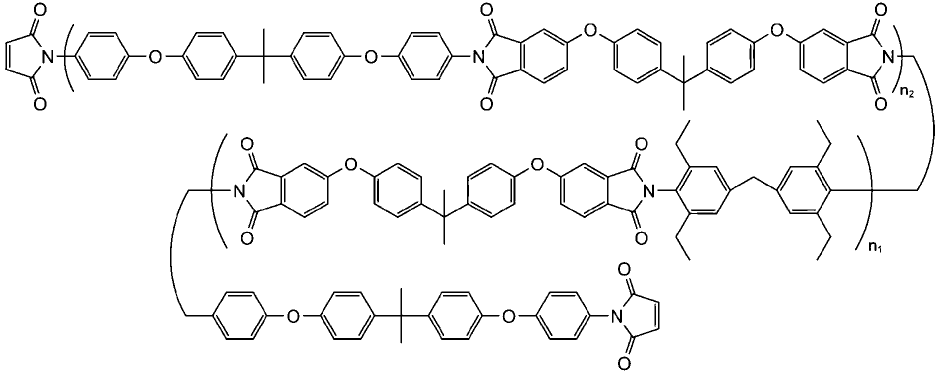 wherein n₁ ≈ 10 (average value), and n₂ ≈ 1 (average value).
(A-2-2): 4,4'-Diphenylmethane bismaleimide (BMI-1000, manufactured by Daiwakasei Industry Co., Ltd.)
(A-2-3): Biphenylmethylene maleimide resin (MIR-3000, manufactured by Nippon Kayaku Co., Ltd.)

### [(A-3) Other Resins for Comparative Examples (Excluding Epoxy Resin)]

(A-3-1): Modified polyphenylene ether resin (SA-9000, manufactured by SABIC)
(A-3-2): Styrene-ethylene-butadiene copolymer thermoplastic resin (Tuftec H-1041, manufactured by Asahi Kasei Corporation)

### [(B) Epoxy Resin Having Two or More Epoxy Groups in One Molecule]

(B-1): Solid bisphenol A-type epoxy resin (jER-1001, manufactured by Mitsubishi Chemical Corporation, epoxy equivalent: 475, softening point: 64°C)
(B-2): Trisphenol methane-type epoxy resin (EPPN-501S, manufactured by Nippon Kayaku Co., Ltd., epoxy equivalent 166, softening point 54°C)
(B-3): Amino-type epoxy resin (jER-630, manufactured by Mitsubishi Chemical Corporation, epoxy equivalent 95, liquid)

### [(C-1) Anionic Polymerization Initiator]

(C-1-1): 2-Undecylimidazole (C11Z, manufactured by Shikoku Kasei Holdings Corporation)
(C-1-2): 2,4-Diamino-6-[2'-undecylimidazolyl-(1')]-ethyl-s-triazine (C11Z-A, manufactured by Shikoku Kasei Holdings Corporation)
(C-1-3): Triphenylphosphine (TPP, manufactured by Hokko Chemical Industry Co., Ltd.)

### [(C-2) Material Other than Anionic Polymerization Initiator for Comparative Examples]

(C-2-1): Dicumyl peroxide (Perkadox BC-FF, manufactured by Kayaku Nouryon Corporation)
(C-2-2): 4-Dimethylaminopyridine (abbreviated as DMAP, manufactured by Tokyo Chemical Industry Co., Ltd.)

### [(D) Inorganic Filler]

(D-1): Toluene slurry of spherical silica having an average particle diameter of 0.5 µm (5SV-CT1, Admatechs Co., Ltd., solid concentration: 75% by mass)

### [(E) Material for Comparative Examples]

(E-1): Epoxy resin-containing build-up film (GL-102, manufactured by Ajinomoto Co., Inc., thickness: 10 µm)
(E-2): Epoxy resin-containing sheet-type encapsulant (MLQ-7700, manufactured by Shin-Etsu Chemical Co., Ltd., thickness: 40 µm)

### <Preparation of Resin Varnish>

Using the formulations given in Tables 1 to 4, each component listed in Tables 1 to 4 was placed into a 500-mL four-necked flask equipped with a Dimroth condenser and a stirrer. The mixture was stirred at 80°C for 2 hours to prepare a varnish-like resin composition (resin varnish).

### <Preparation of Uncured Resin Film and Film Properties>

For each resin varnish that was successfully prepared according to the above procedure, the resin varnish was applied, using a roller coater, onto release-treated PET films (TN-010, manufactured by Toyobo STC Co., Ltd.) having a thickness of 50 µm, which served as substrates, and then dried at 120°C for 5 minutes to prepare uncured resin films having thicknesses of 10 µm and 100 µm. When the uncured resin film having a thickness of 10 µm with the substrate was bent at an angle of 90°, uncured resin films in which no damage such as cracking or chipping was observed were evaluated as good, whereas uncured resin films in which such damage was observed were evaluated as poor, and no further evaluation was performed.

As materials for comparative examples, (E-1) a film having a thickness of 10 µm and (E-2) a film having a thickness of 40 µm were used.

### <Tensile Modulus, Elongation>

A test specimen having a width of 10 mm and a length of 100 mm was prepared from the uncured resin film having a thickness of 100 µm obtained as described above using a vacuum press machine (manufactured by Nikko-Materials Co., Ltd.), a stainless steel frame having a thickness of 100 µm, and a PET film (TN-010). The forming using a press machine was performed under the forming conditions given in Tables 1 to 4, and all post-curing was performed at 180°C for 2 hours in a nitrogen atmosphere. The tensile modulus and elongation at break of the resulting test specimen were measured using an Autograph (AGS-500NS, manufactured by Shimadzu Corporation) under conditions of a grip width of 50 mm and a crosshead speed of 30 mm/min.

### <Peel Strength>

A glass base (EAGLE XG manufactured by Corning Incorporated) made of borosilicate glass and having a width of 25 mm, a length of 75 mm, and a thickness of 1 mm, a copper foil having a surface roughness Rz, as measured by a method in accordance with JIS B 0601, of 0.6 µm and a thickness of 18 µm, and the uncured resin film having a thickness of 10 µm prepared as described above were provided. The thermosetting maleimide resin composition was placed between the glass base and the copper foil, and lamination was performed using a vacuum laminator (manufactured by Nikko-Materials Co., Ltd.) at 80°C to 130°C and 0.5 MPa for 60 seconds. The resulting laminate was further cured by heat treatment at 180°C for 2 hours to prepare a test specimen. To evaluate the adhesion, the 90° peel adhesive strength (kN/m) when the copper foil of each adhesive test specimen was peeled off from the glass base at a temperature of 23°C, a peel angle of 90°, and a crosshead speed of 50 mm/min in accordance with JIS C6481:1996 "Test methods for copper-clad laminates for printed wiring boards" was measured. The location of the peel was observed during the test. Test specimens in which peeling occurred between the copper foil and the resin composition were designated as A, and test specimens in which peeling occurred between the resin composition and the glass base were designated as B.

Furthermore, separate adhesion test specimens prepared by the above method were conditioned under two different environments: one was left to stand at 85°C and 85% RH for 24 hours, and another was left to stand at 150°C for 24 hours. Thereafter, the 90°-peel adhesive strength (kN/m) when the copper foil of each adhesive test specimen was peeled off from the glass base at a temperature of 23°C, a peel angle of 90°, and a crosshead speed of 50 mm/min, similarly in accordance with JIS C6481:1996 "Test methods for copper-clad laminates for printed wiring boards" was measured. The location of the peel was also observed in the same manner as described above, and the results were recorded in the same way.

A sample that failed to be laminated when the lamination temperature was varied within the range of 80 to 130°C was not evaluated.

### <Warpage Measurement>

The above resin composition was shaped on a 12-inch/775-µm-thick silicon wafer using a vacuum press machine (manufactured by Nikko-Materials Co., Ltd.), a 400-µm-thick stainless steel frame, and a PET film (TN-010) in such a manner that the resin thickness after molding was 400 µm. The molding conditions were set to be the same as those used in the vacuum press machine for producing the test specimen for tensile modulus and elongation measurement. After post-curing at 180°C for 2 hours, the warpage of the wafer was measured using a shadow moire-type warpage measurement device (manufactured by Akrometrix).

### <Reliability Test>

A glass base, made of borosilicate glass, having dimensions of 100 mm × 100 mm and a thickness of 0.5 mm, the 10-µm-thick thermosetting resin composition films prepared in Working Examples 3 and 6 and Comparative Example 1, and a 10-µm-thick GL-102 film (E-1) of Comparative Example 15 were provided.

In accordance with the combinations given in Table 5, each thermosetting resin was laminated onto the glass base using a vacuum laminator (manufactured by Nikko-Materials Co., Ltd.), and the laminate was further cured by heat treatment at 180°C for 2 hours to prepare a test specimen. The lamination conditions are described in Table 5. Each test specimen was left to stand under conditions of 85°C and 85% RH for 72 hours, and then subjected to five cycles of immersion in a solder bath heated to 260°C for 20 seconds and immersion in an acetone bath at 25°C for 20 seconds. After the test, each specimen was observed. A test specimen with no peeling of the thermosetting resin layer was rated as good, a test specimen with partial peeling was rated as fair, and a test specimen with the thermosetting resin layer completely detached from the glass base was rated as poor. The results are presented in Table 5.

**Table 1**

| Composition formulation table (parts by mass) | | | Working Example | | | | | |
|---|---|---|---|---|---|---|---|---|
| | | | 1 | 2 | 3 | 4 | 5 | 6 |
| (A) | BMI-2500 | A-1-1 | | | | | | |
| | SLK-3000 | A-1-2 | 95.0 | 95.0 | 95.0 | 95.0 | 95.0 | 95.0 |
| | SLK-1500 | A-1-3 | | | | | | |
| | SLK-6100 | A-2-1 | | | | | | |
| | BMI- 1000 | A-2-2 | | | | | | |
| | MIR-3000 | A-2-3 | | | | | | |
| | SA-9000 | A-3-1 | | | | | | |
| | H-1041 | A-3-2 | | | | | | |
| (B) | jER-1001 | B-1 | 5.0 | | | | | |
| | EPPN-501S | B-2 | | 5.0 | | | | |
| | jER-630 | B-3 | | | 5.0 | 5.0 | 5.0 | 5.0 |
| (C) | C11Z | C-1-1 | 1.0 | 1.0 | 1.0 | | | |
| | C11Z-A | C-1-2 | | | | 1.0 | | 1.0 |
| | TPP | C-1-3 | | | | | 1.0 | |
| | Perkadox BC-FF | C-2-1 | | | | | | |
| | DMAP | C-2-2 | | | | | | |
| (D) | 5SV-CT1 Values in parentheses indicate parts on a solid basis* | D-1 | | | | | | 71.4 (50.0) |
| (Solvent) | Anisole | | | | | | | |
| | Toluene | | 100.0 | 100.0 | 100.0 | 100.0 | 100.0 | 80.0 |
| Film properties | | | good | good | good | good | good | good |
| Forming conditions | | | 170°C, 8 min | 170°C, 8 min | 170°C, 8 min | 170°C, 10 min | 180°C, 10 min | 170°C, 10 min |
| Conditions for selection | Initial peel strength | kN/m | 1.2 | 1.2 | 1.4 | 1.5 | 1.0 | 1.2 |
| | | Peeling surface | A | A | A | A | A | A |
| | Peel strength after moisture absorption | kN/m | 0.8 | 0.8 | 0.9 | 1.0 | 0.7 | 0.8 |
| | | Peeling surface | B | B | A | A | B | A |
| | Peel strength after heat treatment | kN/m | 1.1 | 1.1 | 1.4 | 1.5 | 1.1 | 1.3 |
| | | Peeling surface | A | A | A | A | A | A |
| Evaluation results | Warpage measurement | µm | 150 | 160 | 120 | 130 | 132 | 100 |
| | Tensile modulus | MPa | 120 | 120 | 130 | 130 | 110 | 420 |
| | Elongation | % | 150 | 150 | 160 | 170 | 115 | 65 |

| | | | | | | | | |
|---|---|---|---|---|---|---|---|---|
| *The numerical values in parentheses for the component D indicate the actual parts of the inorganic filler. | | | | | | | | |

**Table 2**

| Composition formulation table (parts by mass) | | | Working Example | | | | |
|---|---|---|---|---|---|---|---|
| | | | 7 | 8 | 9 | 10 | 11 |
| (A) | BMI-2500 | A-1-1 | | 10.0 | | | |
| | SLK-3000 | A-1-2 | 70.0 | 85.0 | 70.0 | 95.0 | 90.0 |
| | SLK-1500 | A-1-3 | 25.0 | | 15.0 | | |
| | SLK-6100 | A-2-1 | | | | | |
| | BMI-1000 | A-2-2 | | | | | |
| | MIR-3000 | A-2-3 | | | | | 5.0 |
| | SA-9000 | A-3-1 | | | | | |
| | H-1041 | A-3-2 | | | | | |
| (B) | jER-1001 | B-1 | | | | | |
| | EPPN-501S | B-2 | | | 100 | | |
| | jER-630 | B-3 | 5.0 | 5.0 | 5.0 | 5.0 | 5.0 |
| (C) | C11Z | C-1-1 | | | | | |
| | C11Z-A | C-1-2 | 1.0 | 1.0 | 1.0 | 1.0 | 1.0 |
| | TPP | C-1-3 | | | | | |
| | Perkadox BC-FF | C-2-1 | | | | | |
| | DMAP | C-2-2 | | | | | |
| (D) | 5SV-CT1 Values in parentheses indicate parts on a solid basis* | D-1 | 71.4 (50.0) | 71.4 (50.0) | | 133.3 (100.0) | |
| (Solvent) | Anisole | | | | | | |
| | Toluene | | 80.0 | 80.0 | 100.0 | 80.0 | 100.0 |
| Film properties | | | good | good | good | good | good |
| Forming conditions | | | 170°C, 10 min | 170°C, 10 min | 170°C, 10 min | 170°C, 10 min | 170°C, 10 min |
| Conditions for selection | Initial peel strength | kN/m | 1.3 | 1.2 | 1.0 | 1.1 | 1.0 |
| | | Peeling surface | A | A | A | A | A |
| | Peel strength after moisture absorption | kN/m | 0.9 | 0.8 | 0.7 | 0.8 | 0.6 |
| | | Peeling surface | A | B | A | A | B |
| | Peel strength after heat treatment | kN/m | 1.4 | 1.3 | 1.0 | 1.2 | 1.2 |
| | | Peeling surface | A | A | A | A | A |
| Evaluation results | Warpage measurement | µm | 85 | 190 | 210 | 100 | 190 |
| | Tensile modulus | MPa | 340 | 560 | 390 | 620 | 330 |
| | Elongation | % | 70 | 40 | 68 | 40 | 105 |

| | | | | | | | |
|---|---|---|---|---|---|---|---|
| *The numerical values in parentheses for the component D indicate the actual parts of the inorganic filler. | | | | | | | |

**Table 3**

| Composition formulation table (parts by mass) | | | Comparative Example | | | | | |
|---|---|---|---|---|---|---|---|---|
| | | | 1 | 2 | 3 | 4 | 5 | 6 |
| (A) | BMI-2500 | A-1-1 | | | | | | |
| | SLK-3000 | A-1-2 | 100.0 | 80.0 | | | | |
| | SLK-1500 | A-1-3 | | 20.0 | | | | |
| | SLK-6100 | A-2-1 | | | 100.0 | 80.0 | | |
| | BMI-1000 | A-2-2 | | | | | 100.0 | |
| | MIR-3000 | A-2-3 | | | | | | 100.0 |
| | SA-9000 | A-3-1 | | | | | | |
| | H-1041 | A-3-2 | | | | | | |
| (B) | jER-1001 | B-1 | | | | | | |
| | EPPN-501S | B-2 | | | | | | |
| | jER-630 | B-3 | | | | 20.0 | | |
| (C) | C11Z | C-1-1 | | | | | | |
| | C11Z-A | C-1-2 | | | | 1.0 | | |
| | TPP | C-1-3 | | | | | | |
| | Perkadox BC-FF | C-2-1 | 1.0 | 1.0 | 1.0 | | | |
| | DMAP | C-2-2 | | | | | | |
| (D) | 5SV-CT1 Values in parentheses indicate parts on a solid basis* | D-1 | | | | | | |
| (Solvent) | Anisole | | | | 200.0 | | 200.0 | |
| | Toluene | | 100.0 | 75.0 | | 100.0 | 100.0 | |
| Film properties | | | good | good | good | good | poor | poor |
| Forming conditions | | | 150°C, 5 min | 150°C, 6 min | 180°C, 5 min | 180°C, 10 min | not evaluated | not evaluated |
| Conditions for selection | Initial peel strength | kN/m | 1.2 | 1.6 | forming and lamination not possible | 0.6 | | |
| | | Peeling surface | B | B | | B | | |
| | Peel strength after moisture absorption | kN/m | <0.1 | <0.2 | | 0.2 | | |
| | | Peeling surface | B | B | | B | | |
| | Peel strength after heat treatment | kN/m | 1.1 | 1.4 | | 0.6 | | |
| | | Peeling surface | A | A | | A | | |
| Evaluation results | Warpage measurement | µm | 160 | 130 | | 1120 | | |
| | Tensile modulus | MPa | 110 | 100 | 1800 | 1900 | | |
| | Elongation | % | 160 | 165 | 10 | 10 | | |

| | | | | | | | | |
|---|---|---|---|---|---|---|---|---|
| *The numerical values in parentheses for the component D indicate the actual parts of the inorganic filler. | | | | | | | | |

**Table 4**

| Composition formulation table (parts by mass) | | | Comparative Example | | | | |
|---|---|---|---|---|---|---|---|
| | | | 7 | 8 | 9 | 10 | 11 |
| (A) | BMI-2500 | A-1-1 | | | | E-1 | E-2 |
| | SLK-3000 | A-1-2 | | | | | |
| | SLK-1500 | A-1-3 | | 95.0 | | | |
| | SLK-6100 | A-2-1 | | | | | |
| | BMI-1000 | A-2-2 | | | | | |
| | MIR-3000 | A-2-3 | | | 10.0 | | |
| | SA-9000 | A-3-1 | 60.0 | | 50.0 | | |
| | H-1041 | A-3-2 | 40.0 | | 40.0 | | |
| (B) | jER-1001 | B-1 | | | | | |
| | EPPN-501S | B-2 | | | | | |
| | jER-630 | B-3 | | 5.0 | | | |
| (C) | C11Z | C-1-1 | | | | | |
| | C11Z-A | C-1-2 | | | | | |
| | TPP | C-1-3 | | | | | |
| | Perkadox BC-FF | C-2-1 | 1.0 | | 1.0 | | |
| | DMAP | C-2-2 | | 1.0 | | | |
| (D) | 5SV-CT1 Values in parentheses indicate parts on a solid basis* | D-1 | | | | | |
| (Solvent) | Anisole | | | | | | |
| | Toluene | | 400.0 | 100.0 | 400.0 | | |
| Film properties | | | good | Varnish gelled** | good | good | good |
| Forming conditions | | | 150°C, 5 min | | 150°C, 5 min | 150°C, 10 min | 150°C, 10 min |
| Conditions for selection | Initial peel strength | kN/m | 0.3 | | 0.4 | <0.2 | <0.2 |
| | | Peeling surface | B | | B | B | B |
| | Peel strength after moisture absorption | kN/m | <0.1 | | <0.1 | <0.2 | <0.2 |
| | | Peeling surface | B | | B | B | B |
| | Peel strength after heat treatment | kN/m | <0.1 | | 0.3 | <0.2 | <0.2 |
| | | Peeling surface | B | | B | B | B |
| Evaluation results | Warpage measurement | µm | peeled | | 1250 | 2450 | peeled |
| | Tensile modulus | MPa | 800 | | 1200 | 10000 | 11000 |
| | Elongation | % | 15 | | 5 | <2 | <2 |

| | | | | | | | |
|---|---|---|---|---|---|---|---|
| *The numerical values in parentheses for the component D indicate the actual parts of the inorganic filler. **The curing reaction proceeded immediately, and film formation was not possible. | | | | | | | |

**Table 5**

| | | Working Example 11 | Working Example 12 | Working Example 13 | Working Example 14 | Comparative Example 14 | Comparative Example 15 | Comparative Example 16 |
|---|---|---|---|---|---|---|---|---|
| Resin layer on glass base | Resin type | Working Example 3 | Working Example 3 | Working Example 6 | Working Example 3 | Comparative Example 1 | GL-102 | Comparative Example 1 |
| | Lamination conditions | 80 °C, 60 s, 0.3 MPa | 80 °C, 60 s, 0.3 MPa | 80 °C, 60 s, 0.5 MPa | 80 °C, 60 s, 0.3 MPa | 80 °C, 60 s, 0.3 MPa | 130 °C, 60 s, 0.5 MPa | 80 °C, 60 s, 0.3 MPa |
| Upper layer on the resin layer | Resin type | none | GL-102 | GL-102 | Working Example 6 | none | none | GL-102 |
| | Lamination conditions | | 130 °C, 60 s, 0.5 MPa | 130 °C, 60 s, 0.5 MPa | 80 °C, 60 s, 0.5 MPa | | | 130 °C, 60 s, 0.5 MPa |
| Evaluation results | | good | good | good | good | fair | poor | poor |

## Claims

1. A thermosetting maleimide resin composition for a stress-relief layer for a glass-core substrate, comprising the components (A) to (C) of:
(A) a maleimide compound having, in one molecule, one or more hydrocarbon groups derived from one or more skeletons selected from dimer diamine skeletons and trimer triamine skeletons, the component (A) being contained in an amount of 30% to 99% by mass based on the total composition;
(B) an epoxy resin having two or more epoxy groups in one molecule, the component (B) being contained in an amount of 0.05 to 25 parts by mass per 100 parts by mass of the component (A); and
(C) an anionic polymerization initiator, the component (C) being contained in an amount of 0.1 to 5 parts by mass per 100 parts by mass of the total of the components (A) and (B),
wherein the thermosetting maleimide resin composition provides a test specimen exhibiting:
(1) a peel strength of 0.8 kN/m or more as determined at 23°C with a peel angle of 90° and a crosshead speed of 50 mm/min in accordance with JIS C6481:1996,
(2) a peel strength of 0.5 kN/m or more, as determined at 23°C with a peel angle of 90°, and a crosshead speed of 50 mm/min in accordance with JIS C6481:1996, after the test specimen has been left to stand at 85°C and a relative humidity of 85% for 24 hours, and
(3) a peel strength of 0.8 kN/m or more, as determined at 23°C with a peel angle of 90°, and a crosshead speed of 50 mm/min in accordance with JIS C6481:1996, after the test specimen has been left to stand at 150°C for 24 hours,
wherein the test specimen is prepared by laminating a copper foil having a thickness of 18 µm and a surface roughness (Rz), as measured by a method in accordance with JIS B 0601, of 0.6 µm onto a borosilicate glass base having a thickness of 1 mm in such a manner that a stress-relief layer is provided between the glass base and the copper foil, the stress-relief layer being formed by applying or laminating the thermosetting maleimide resin composition at a thickness of 10 µm and curing the composition at 180°C for 2 hours.

2. The thermosetting maleimide resin composition for a stress-relief layer for a glass-core substrate according to claim 1, wherein the maleimide compound as the component (A) is a maleimide compound represented by formula (1) defined as: 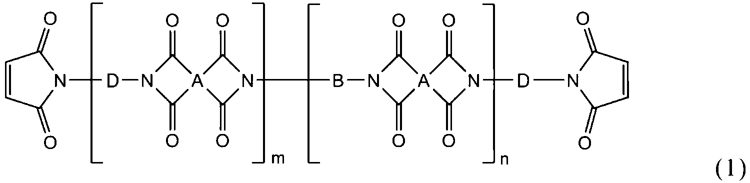 wherein, in the formula (1), each A independently represents a tetravalent organic group having a cyclic structure, each B independently represents a divalent hydrocarbon group having 6 to 60 carbon atoms, each D independently represents a divalent alicyclic hydrocarbon group having 6 to 200 carbon atoms or a hydrocarbon group derived from one or more skeletons selected from dimer diamine skeletons and trimer triamine skeletons, provided that at least one D represents a hydrocarbon group derived from one or more skeletons selected from dimer diamine skeletons and trimer triamine skeletons, m represents an average repeating unit number of 1 to 100, n represents an average repeating unit number of 1 to 200, the order of repeating units enclosed in square brackets subscripted with m and n is not limited, and the mode of linkage is any of alternating, block, and random types.

3. The thermosetting maleimide resin composition for a stress-relief layer for a glass-core substrate according to claim 1, wherein the maleimide compound as the component (A) is a maleimide compound represented by formula (2) defined as: 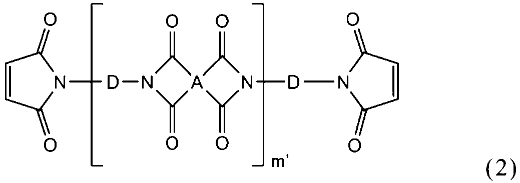 wherein, in the formula (2), each A independently represents a tetravalent organic group having a cyclic structure, each D independently represents a divalent alicyclic hydrocarbon group having 6 to 200 carbon atoms or a hydrocarbon group derived from one or more skeletons selected from dimer diamine skeletons and trimer triamine skeletons, provided that at least one D represents a hydrocarbon group derived from one or more skeletons selected from dimer diamine skeletons and trimer triamine skeletons, and m' represents an average repeating unit number of 1 to 100.

4. The thermosetting maleimide resin composition for a stress-relief layer for a glass-core substrate according to claim 2, wherein each A in the formula (1) independently represents any one of tetravalent organic groups represented by structural formulae defined as: 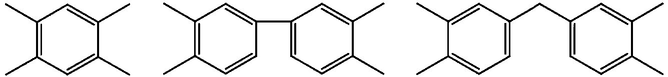 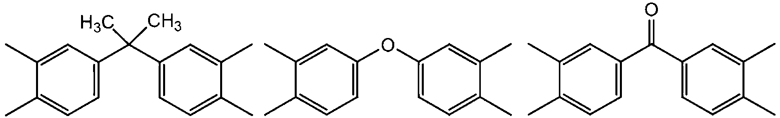 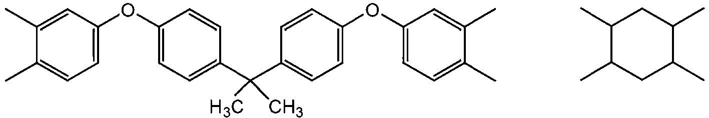 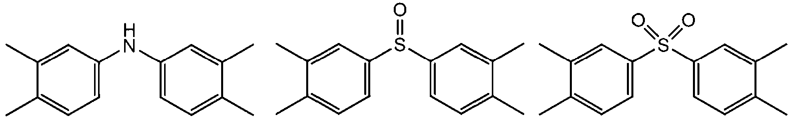 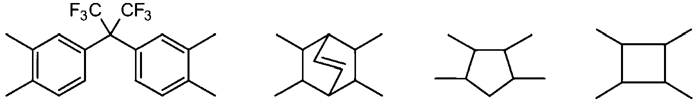 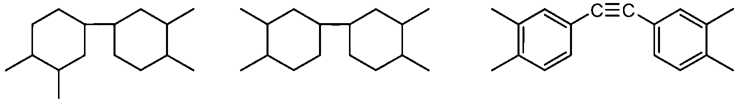 wherein, in each of the above structural formulae, bonding arms that are not bonded are bonded to carbonyl carbons of cyclic imide structures in the formula (1).

5. The thermosetting maleimide resin composition for a stress-relief layer for a glass-core substrate according to claim 1, wherein the epoxy resin (B) is an amino-type epoxy resin.

6. The thermosetting maleimide resin composition for a stress-relief layer for a glass-core substrate according to claim 1, wherein the anionic polymerization initiator (C) is an imidazole compound having a triazine ring.

7. A printed wiring board using the thermosetting maleimide resin composition according to any one of claims 1 to 6.
